# EUROPEAN PATENT SPECIFICATION

(11) **EP 4 033 262 B1**
(45) Date of publication and mention of the grant of the patent: **06.03.2024**
(21) Application number: 21773441.7
(22) Date of filing: 13.08.2021
(51) Int. Cl.: G01R 31/12, G01R 31/14, H04Q 9/00

(54) **PARTIAL DISCHARGE (PD) DETECTION APPARATUS AND METHOD BASED ON CROSS INTERCONNECTION BOX**
VORRICHTUNG UND VERFAHREN ZUR ERKENNUNG VON TEILENTLADUNGEN (PD) BASIEREND AUF EINER KREUZVERBINDUNGSDOSE
APPAREIL ET PROCÉDÉ DE DÉTECTION DE DÉCHARGE PARTIELLE (PD) BASÉ SUR UN BOÎTIER D'INTERCONNEXION CROISÉE

(30) Priority: 26.11.2020 CN 202011349986
(43) Date of publication of application: 27.07.2022
(73) Proprietor: State Grid Shanghai Municipal Electric Power Company, Shanghai 200122 (CN)
(72) Inventor: YUAN, Qi, Shanghai 200072 (CN); ZHOU, Yunjie, Shanghai 200072 (CN); ZHANG, Yi, Shanghai 200072 (CN); YE, Ting, Shanghai 200072 (CN); LI, Hai, Shanghai 200072 (CN); ZHANG, Wei, Shanghai 200072 (CN); XU, Qiang, Shanghai 200072 (CN); ZHOU, Jingjing, Shanghai 200072 (CN); WANG, Pingyu, Shanghai 200072 (CN); LI, Chunhui, Shanghai 200072 (CN); SUN, Xiaoxuan, Shanghai 200072 (CN); YANG, Shuting, Shanghai 200072 (CN); XU, Jiamin, Shanghai 200072 (CN); WANG, Wei, Shanghai 200072 (CN); ZHOU, Jie, Shanghai 200072 (CN)
(74) Representative: Meyer, Thorsten
(86) International application number: PCT/CN2021/112613
(87) International publication number: WO 2022/110907

(56) References cited:
- WO-A1-2019/194754
- CN-A- 102 981 106
- CN-A- 103 308 832
- CN-A- 103 344 889
- CN-A- 103 344 889
- CN-A- 108 872 802
- CN-A- 112 462 199
- CN-U- 204 190 345
- CN-U- 206 671 472
- CN-U- 206 773 053
- CN-U- 206 773 053
- CN-U- 213 875 900
- JP-A- 2000 241 490
- JP-A- 2003 248 027
- JP-B2- H0 792 481
- KR-B1- 102 046 921

## Description

### TECHNICAL FIELD

The present disclosure relates to the field of partial discharge (PD) detection of cables, and in particular, to a PD detection apparatus and method based on a cross interconnection box.

### BACKGROUND

During the operation of a power cable, insulation degradation is caused due to impact of electricity, heat, machinery, and environments, and PD occurs, resulting in breakdown and seriously affecting operation reliability of a power system. At present, high-voltage cables in China are usually grounded through three-phase cross interconnection to reduce an induced voltage and a current of a metal sheath. However, because three-phase cables are connected in a transposed mode by using a cross interconnection box, it is difficult to determine a phase and an interconnection section of a PD signal inside the cable in actual measurement.

In view of the above PD detection problem, of the high-voltage cable, caused by cross interconnection, a most commonly used method is to install a high frequency current transformer (HFCT) on a ground lead of the three-phase cable, and introduce a high-frequency signal on the ground lead into the cross interconnection box by using the HFCT, to detect PD signals of different phases. However, during PD detection on the three-phase cable, three HFCTs need to be installed on site each time, and the signal is introduced into the cross interconnection box by using the HFCTs, which is cumbersome. Reference document CN103344889A discloses a method for measuring partial discharge of a cable with a capacitor jumper. The method includes the following steps: (a) locating the position of the cable head of the cable to be tested and the position of the cross interconnection box near the cable head; (b) clamp the conductive clips at the positions where the shield wires at both ends of the cable head of one phase to be detected in the cross interconnection box are separated, and obtain the shield wire signals to be measured; (c) form the coaxial cable with the obtained shield wire signals, and bridge the jumper capacitance between the coaxial cables of one phase to be measured in the cross interconnection box; (d) connect the signal line connecting the capacitor jumper to the broadband current transformer as the primary side of the broadband current transformer; (e) input the signal coupled by the broadband current transformer to the amplifier for amplification and; (f) read the signal amplified by the amplifier through the detection instrument to determine whether the cable to be tested has partial discharge. Reference document CN206773053U discloses an intelligent wireless monitoring device for cross connection grounding. The device includes a junction well, an auxiliary well arranged beside the junction well, and a control center server, wherein the auxiliary well includes the cross interconnection grounding box and the circulating current monitoring box. The three-phase grounding port of the cross interconnection grounding box corresponds to the protective layer of the three-phase high-voltage cable set in the junction well through the three-phase coaxial grounding cable. The circulating current monitoring box includes a circulating current monitoring module, a wireless communication and positioning module connected with the data of the circulating current monitoring module, and a power module. The circulating current monitoring module is sleeved on the coaxial grounding cable and transmits the current data of the coaxial grounding cable to the wireless communication and positioning module. The wireless communication and positioning module and the wireless signal receiver of the control center server are connected via wireless network data. The control center server is also connected with computer terminals and mobile terminals. Reference document JP2003248027A discloses a partial-discharge measuring device of a power-cable track by which the partial discharge generated from power cables in a plurality of phases can be measured simply and with satisfactory accuracy, and by which the partial discharge of a directly buried power cable can be measured simply. Reference document CN108872802A discloses a distributed monitoring system for partial discharge in cables. The system includes multiple signal detection units, multiple signal processing units, and a monitoring host. Multiple signal detection units are connected to multiple cables led out from a power bus to detect partial discharge pulse signals on the three-phase and grounding wires of the cables; multiple signal processing units, connected to the multiple signal detection units one by one, are used to collect the partial discharge pulse signals signal detected by the signal detection units, and obtain the partial discharge quantities of the cables based on the partial discharge pulse signals; the monitoring host is connected to the multiple signal processing units for collecting the partial discharge amount of the cables calculated by the multiple signal processing units, and displaying and storing the partial discharge amount for processing. Reference document JP2000241490A discloses a lead wire connection structure for a partial discharge measurement which does not use a foil electrode, but can connect a lead wire to a metal tube jacket easily when carrying out the same measurement, and can shorten lead wire length.

### SUMMARY

To overcome the above defects in the prior art, the present invention provides a PD detection apparatus and method based on a cross interconnection box as defined by the independent claims 1 and 4, respectively, which can be operated easily and can determine a phase and an interconnection section of a PD signal.

The objective of the present invention can be achieved by the following technical solutions:

The present invention provides a PD detection apparatus based on a cross interconnection box, wherein the cross interconnection box includes a first A terminal and a second A terminal that are connected to each other, a first B terminal and a second B terminal that are connected to each other, and a first C terminal and a second C terminal that are connected to each other, wherein the first A terminal, the first B terminal, and the first C terminal are connected to three cables respectively, and the PD detection apparatus further includes a processor and three capacitor impedance arms that are respectively connected between the first A terminal and the second C terminal, between the first B terminal and the second A terminal, and between the first C terminal and the second B terminal, and
the capacitor impedance arms each include a capacitor and an impedance plate that are connected in series, a branch in a connection line between the capacitor and the impedance plate is connected to a pulse signal detection module for detecting a pulse voltage signal, and each pulse signal detection module is connected to the processor,
wherein each pulse signal detection module is further connected to a first wireless transmission circuit, the processor is provided with a second wireless transmission circuit, and the pulse signal detection module is connected to the second wireless transmission circuit by using the first wireless transmission circuit, and then connected to the processor,
wherein the first A terminal, the first B terminal, and the first C terminal each are connected to a cable by using a clamp, and the clamp is made from an insulating material,
wherein the first wireless transmission circuit and the second wireless transmission circuit have a same structure and are both Bluetooth wireless circuits, wireless-fidelity (Wi-Fi) wireless circuits, or Internet of Things (IoT) wireless circuits,
wherein each pulse signal detection module includes a microprocessor and an amplifier circuit, wherein the amplifier circuit is connected to the microprocessor and the connection line between the capacitor and the impedance plate, and the microprocessor is further connected to the first wireless transmission circuit, and
wherein the second A terminal, the second B terminal, and the second C terminal are grounded, and the three cables are grounded.

Further, the three capacitor impedance arms adopt capacitors and impedance plates of a same model and specification.

Further, there is one processor, and the three pulse signal detection modules are connected to the same processor.

The present invention further provides a PD detection method using the above-mentioned PD detection apparatus based on a cross interconnection box, wherein the method includes the following steps:
installing the cables in the cross interconnection box; obtaining a pulse voltage signal of each capacitor impedance arm in real time; and detecting a PD signal based on the pulse voltage signal.

Compared with the prior art, the present invention has the following advantages:
(1) In the present invention, the capacitor impedance arms are separately installed between the A and C terminals, between the B and A terminals, and between the C and B terminals in the cross interconnection box, to measure an output impedance voltage, and obtain a PD signal of each phase in the cable, thereby improving the detection method, enhancing the PD signal, and improving detection efficiency.
(2) In the present invention, the pulse voltage signals obtained by the capacitor impedance arms are wirelessly transmitted to an external system, and the system first determines whether each phase has a PD signal. This can greatly facilitate PD detection on each phase in a three-phase cross-interconnected cable.
(3) A ground down lead of the cable is connected to each of the A, B, and C terminals of the cross interconnection box by using a clamp free from PD. The clamp is made from an insulating material to avoid an interference signal.
(4) In the present invention, wireless data transmission is performed by using the Bluetooth wireless circuit, the Wi-Fi wireless circuit, or the IoT wireless circuit. This does not rely on a communication base station of a mobile network to establish a wireless communication network, improves real-time transmission of PD data, and avoids a misjudgment caused by a delay of data transmission.

### BRIEF DESCRIPTION OF THE DRAWINGS

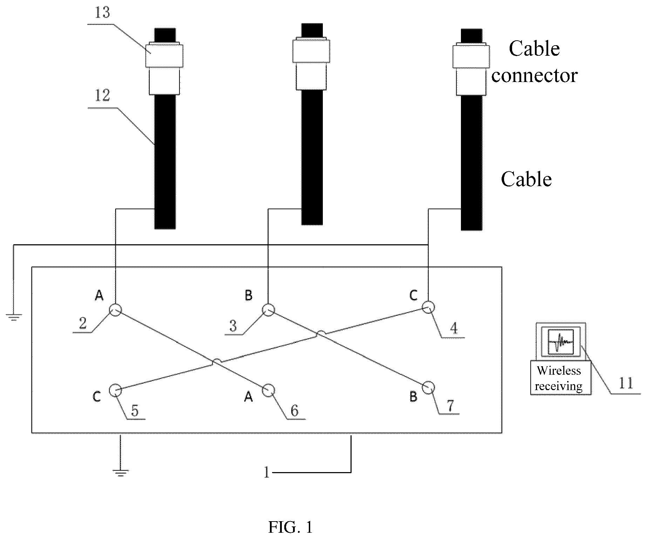

FIG. 1 is a schematic diagram of an overall structure of a PD detection apparatus based on a cross interconnection box according to the present invention; and

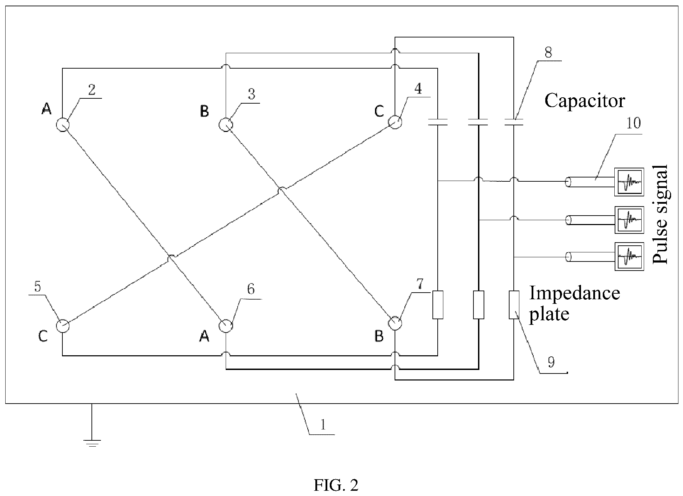

FIG. 2 is an internal circuit diagram of a cross interconnection box according to the present invention.

Numeral references: 1: cross interconnection box; 2: first A terminal; 3: first B terminal; 4: first C terminal; 5: second C terminal; 6: second A terminal; 7: second B terminal; 8: capacitor; 9: impedance plate; 10: pulse signal detection module; 11: processor; 12: cable; and 13: cable connector.

### DETAILED DESCRIPTION

The present disclosure is now described below in detail with reference to the accompanying drawings and a specific embodiment. The embodiment is implemented on the premise of the technical solutions of the present invention.

The following presents the detailed implementation and specific operation process. The protection scope of the present invention, however, is not limited to the following embodiment.

### Embodiment 1

This embodiment provides a PD detection apparatus based on a cross interconnection box. Capacitor impedance arms AC, BA and CB are disposed in a cross interconnection box 1, to convert a PD pulse current signal of a ground down lead of a three-phase cross-interconnected cable and output a pulse voltage signal of each phase, and the converted signal is input into a system by using a wireless transmission system, to detect PD of each phase in the three-phase cross-interconnected cable. This solution is easy to operate, simple, and practical, and can quickly detect a PD signal of each phase in the three-phase cross-interconnected cable.

The cross interconnection box 1 includes a first A terminal 2 and a second A terminal 6 that are connected to each other, a first B terminal 3 and a second B terminal 7 that are connected to each other, and a first C terminal 4 and a second C terminal 5 that are connected to each other, wherein the first A terminal 2, the first B terminal 3, and the first C terminal 4 are connected to three cables 12 respectively. The PD detection apparatus further includes a processor 11 and three capacitor impedance arms that are respectively connected between the first A terminal 2 and the second C terminal 5, between the first B terminal 3 and the second A terminal 6, and between the first C terminal 4 and the second B terminal 7.

The capacitor impedance arms each include a capacitor 8 and an impedance plate 9 that are connected in series, a branch in a connection line between the capacitor 8 and the impedance plate 9 is connected to a pulse signal detection module 10 for detecting a pulse voltage signal, and each pulse signal detection module 10 is connected to the processor 11. The second A terminal 6, the second B terminal 7, and the second C terminal 5 are grounded, and the three cables 12 are grounded.

Each pulse signal detection module 10 is wirelessly connected to the processor 11, thereby avoiding inconvenience caused by a wired connection. Specifically, each pulse signal detection module 10 is further connected to a first wireless transmission circuit, the processor 11 is provided with a second wireless transmission circuit, and the pulse signal detection module 10 is connected to the second wireless transmission circuit by using the first wireless transmission circuit, and then connected to the processor 11. The first wireless transmission circuit and the second wireless transmission circuit have a same structure and are both Bluetooth wireless circuits, Wi-Fi wireless circuits, or IoT wireless circuits. In this mode, a wireless communication network is established without relying on a communication base station of a mobile network, and PD data is transmitted in real time, thereby avoiding a misjudgment caused by a delay of data transmission.

Each pulse signal detection module 10 includes a microprocessor and an amplifier circuit, wherein the amplifier circuit is connected to the microprocessor and the connection line between the capacitor 8 and the impedance plate 9, and the microprocessor is further connected to the first wireless transmission circuit.

The first A terminal 2, the first B terminal 3, and the first C terminal 4 each are connected to a cable 12 by using a clamp. The clamp is made from an insulating material to ensure that no PD occurs on the clamp, thereby avoiding an interference signal.

In this embodiment, the three capacitor impedance arms adopt capacitors 8 and impedance plates 9 of a same model and specification. There is one processor 11, and the three pulse signal detection modules 10 are connected to the same processor 11. One end of each cable 12 is connected to a cable connector 13, and then connected to the cross interconnection box 1.

This embodiment further provides a PD detection method using the above-mentioned PD detection apparatus based on a cross interconnection box, wherein the method includes the following steps:
installing the cables in the cross interconnection box; obtaining a pulse voltage signal of each capacitor impedance arm in real time; and detecting a PD signal based on the pulse voltage signal.

The working principle of this solution is as follows:
The capacitor impedance arms are separately installed between the A and C terminals, between the B and A terminals, and between the C and B terminals in the cross interconnection box 1 to obtain the PD signal of each phase in the three-phase cross-interconnected cable by using an output impedance voltage measurement and display apparatus, and can be connected to an external system by using a wireless transmission technology. When PD caused by an internal defect occurs in the three-phase cross-interconnected cable, a corresponding PD pulse current signal is converted into a pulse voltage signal by using each capacitor impedance arm in the cross interconnection box 1, and then the pulse voltage signal is wirelessly transmitted to the external system. The system first determines whether each phase has a PD signal. This enhances the PD signal, and greatly increases a detectable rate of PD in the three-phase cross-interconnected cable.

In this solution, the PD signal in the three-phase cross-interconnected cable can be detected by using the capacitor impedance arms, and an electrical signal obtained through internal conversion is transmitted to the external system through wireless transmission. Therefore, this solution can be suitable for PD detection in the three-phase cross-interconnected cable.

The foregoing is a detailed description of the preferred specific embodiments of the present invention. It should be understood that a person of ordinary skill in the art can make various modifications and variations according to the concept of the present invention without creative efforts. Therefore, all such modifications and variations shall fall within the protection scope of the present invention as defined by the appended claims.

## Claims

1. A partial discharge (PD) detection apparatus based on a cross interconnection box (1), wherein the cross interconnection box (1) comprises a first A terminal (2) and a second A terminal (6) that are connected to each other, a first B terminal (3) and a second B terminal (7) that are connected to each other, and a first C terminal (4) and a second C terminal (5) that are connected to each other, wherein the first A terminal (2), the first B terminal (3), and the first C terminal (4) are connected to three cables (12) respectively, and wherein the second A terminal (6), the second B terminal (7), and the second C terminal (5) are grounded, the PD detection apparatus further comprising three capacitor impedance arms that are respectively connected between the first A terminal (2) and the second C terminal (5), between the first B terminal (3) and the second A terminal (6), and between the first C terminal (4) and the second B terminal (7), wherein and the capacitor impedance arms each comprise a capacitor (8) and an impedance plate (9) that are connected in series, and wherein a branch in a connection line between the capacitor (8) and the impedance plate (9) is connected to a pulse signal detection module (10) for detecting a pulse voltage signal, **characterized in that** the PD detection apparatus further comprises a processor (11), that each pulse signal detection module (10) is connected to the processor (11), that each pulse signal detection module (10) is further connected to a first wireless transmission circuit, the processor (11) is provided with a second wireless transmission circuit, and the pulse signal detection module (10) is connected to the second wireless transmission circuit by using the first wireless transmission circuit, and then connected to the processor (11), that the first A terminal (2), the first B terminal (3), and the first C terminal (4) each are connected to a cable (12) by using a clamp, and the clamp is made from an insulating material, that the first wireless transmission circuit and the second wireless transmission circuit have a same structure and are both Bluetooth wireless circuits, wireless-fidelity (Wi-Fi) wireless circuits, or Internet of Things (IoT) wireless circuits, that each pulse signal detection module (10) comprises a microprocessor and an amplifier circuit, wherein the amplifier circuit is connected to the microprocessor and the connection line between the capacitor (8) and the impedance plate (9), and the microprocessor is further connected to the first wireless transmission circuit, and that the three cables (12) are grounded.

2. The PD detection apparatus based on a cross interconnection box (1) according to claim 1,
wherein the three capacitor impedance arms adopt capacitors (8) and impedance plates (9) of a same model and specification.

3. The PD detection apparatus based on a cross interconnection box (1) according to claim 1,
wherein there is one processor (11), and the three pulse signal detection modules (10) are connected to the same processor (11).

4. APD detection method using the PD detection apparatus based on a cross interconnection box (1) according to claim 1, wherein the method comprises the following steps:
installing the cables (12) in the cross interconnection box (1); obtaining a pulse voltage signal of each capacitor impedance arm in real time;
and detecting a PD signal based on the pulse voltage signal.

## Patentansprüche

1. Vorrichtung zur Erkennung von Teilentladungen (PD), basierend auf einer Kreuzverbindungsdose (1), wobei die Kreuzverbindungsdose (1) einen ersten A-Anschluss (2) und einen zweiten A-Anschluss (6) umfasst, die miteinander verbunden sind, einen ersten B-Anschluss (3) und einen zweiten B-Anschluss (7), die miteinander verbunden sind, und einen ersten C-Anschluss (4) und einen zweiten C-Anschluss (5), die miteinander verbunden sind, wobei der erste A Anschluss (2), der erste B-Anschluss (3) und der erste C-Anschluss (4) jeweils mit drei Kabeln (12) verbunden sind, und wobei der zweite A-Anschluss (6), der zweite B-Anschluss (7) und der zweite C-Anschluss (5) geerdet ist, wobei die PD-Erkennungsvorrichtung weiterhin drei Kondensatorimpedanzzweige umfasst, die jeweils zwischen dem ersten A-Anschluss (2) und dem zweiten C-Anschluss (5), zwischen dem ersten B-Anschluss (3) und angeschlossen sind dem zweiten A-Anschluss (6) und zwischen dem ersten C-Anschluss (4) und dem zweiten B-Anschluss (7), wobei die Kondensatorimpedanzzweige jeweils einen Kondensator (8) und eine Impedanzplatte (9) umfassen, die in Reihe geschaltet sind , und wobei ein Zweig in einer Verbindungsleitung zwischen dem Kondensator (8) und der Impedanzplatte (9) mit einem Pulssignal-Erfassungsmodul (10) zum Erfassen eines Pulsspannungssignals verbunden ist, **dadurch gekennzeichnet, dass** die PD-Erkennungsvorrichtung weiterhin einen Prozessor (11) umfasst, dass jedes Pulssignal-Erkennungsmodul (10) mit dem Prozessor (11) verbunden ist, dass jedes Pulssignal-Erkennungsmodul (10) außerdem mit einer ersten drahtlosen Übertragung verbunden ist Schaltung, der Prozessor (11) ist mit einer zweiten drahtlosen Übertragungsschaltung ausgestattet, und das Pulssignalerkennungsmodul (10) ist unter Verwendung der ersten drahtlosen Übertragungsschaltung mit der zweiten drahtlosen Übertragungsschaltung verbunden und dann mit dem Prozessor (11) verbunden, dass der erste A-Anschluss (2), der erste B-Anschluss (3) und der erste C-Anschluss (4) jeweils mit einem Kabel (12) unter Verwendung einer Klemme verbunden sind und die Klemme aus einem isolierenden Material hergestellt ist, dass die erste Schaltung zur drahtlosen Übertragung und die zweite Schaltung zur drahtlosen Übertragung haben die gleiche Struktur und sind beide drahtlose Bluetooth-Schaltungen, drahtlose Schaltungen mit drahtloser Wireless Fidelity (Wi-Fi) oder drahtlose Schaltungen für das Internet der Dinge (loT), dass jedes Impulssignal-Erkennungsmodul (10) einen Mikroprozessor und eine Verstärkerschaltung umfasst, wobei die Verstärkerschaltung mit dem Mikroprozessor und der Verbindungsleitung zwischen dem Kondensator (8) und der Impedanzplatte (9) verbunden ist und der Mikroprozessor weiterhin mit der ersten drahtlosen Übertragungsschaltung verbunden ist, und dass die drei Kabel (12) geerdet sind.

2. PD-Erkennungsvorrichtung basierend auf einer Kreuzverbindungsdose (1) nach Anspruch 1, wobei die drei Kondensatorimpedanzzweige Kondensatoren (8) und Impedanzplatten (9) desselben Modells und derselben Spezifikation verwenden.

3. PD-Erkennungsvorrichtung basierend auf einer Kreuzverbindungsdose (1) nach Anspruch 1, wobei ein Prozessor (11) vorhanden ist und die drei Pulssignalerkennungsmodule (10) mit demselben Prozessor (11) verbunden sind.

4. PD-Erkennungsverfahren unter Verwendung der PD-Erkennungsvorrichtung basierend auf einer Kreuzverbindungsdose (1) nach Anspruch 1, wobei das Verfahren die folgenden Schritte umfasst: Installieren der Kabel (12) im Kreuzverbindungsdose (1); Erhalten eines Impulsspannungssignals jedes Kondensatorimpedanzzweigs in Echtzeit; und Erkennen eines PD-Signals basierend auf dem Impulsspannungssignal.

## Revendications

1. Appareil de détection de décharge partielle (PD) basé sur un boîtier d'interconnexion croisée (1), dans lequel le boîtier d'interconnexion croisée (1) comprend une première borne A (2) et une seconde borne A (6) qui sont connectées l'une à l'autre, une première borne B (3) et une seconde borne B (7) qui sont connectées l'une à l'autre, et une première borne C (4) et une seconde borne C (5) qui sont connectées l'une à l'autre, la première borne A la borne (2), la première borne B (3) et la première borne C (4) sont connectées respectivement à trois câbles (12), et dans lequel la seconde borne A (6), la seconde borne B (7) et la seconde borne C (5) sont mises à la terre, l'appareil de détection PD comprenant en outre trois bras d'impédance de condensateur qui sont respectivement connectés entre la première borne A (2) et la seconde borne C (5), entre la première borne B (3) et la seconde borne A (6), et entre la première borne C (4) et la seconde borne B (7), les bras d'impédance du condensateur comprenant chacun un condensateur (8) et une plaque d'impédance (9) qui sont connectés en série, et dans lequel une dérivation dans une ligne de connexion entre le condensateur (8) et la plaque d'impédance (9) est connectée à un module de détection de signal d'impulsion (10) pour détecter un signal de tension d'impulsion, **caractérisé en ce que** l'appareil de détection de PD comprend en outre un processeur (11), **en ce que** chaque module de détection de signal pulsé (10) est connecté au processeur (11), **en ce que** chaque module de détection de signal pulsé (10) est en outre connecté à une première transmission sans fil circuit, le processeur (11) est pourvu d'un deuxième circuit de transmission sans fil, et le module de détection de signal d'impulsion (10) est connecté au deuxième circuit de transmission sans fil à l'aide du premier circuit de transmission sans fil, puis connecté au processeur (11), **en ce que** la première borne A (2), la première borne B (3) et la première borne C (4) sont chacune connectées à un câble (12) à l'aide d'une pince, et la pince est constituée d'un matériau isolant, **en ce que** le premier circuit de transmission sans fil et le second circuit de transmission sans fil ont une même structure et sont tous deux des circuits sans fil Bluetooth, des circuits sans fil de fidélité sans fil (Wi-Fi) ou des circuits sans fil Internet des objets (loT), que chaque module de détection de signal d'impulsion (10) comprend un microprocesseur et un circuit amplificateur, le circuit amplificateur étant connecté au microprocesseur et à la ligne de connexion entre le condensateur (8) et la plaque d'impédance (9), et le microprocesseur étant en outre connecté au premier circuit de transmission sans fil, et que les trois câbles (12) sont mis à la terre.

2. Appareil de détection de PD basé sur un boîtier d'interconnexion croisée (1) selon la revendication 1, dans lequel les trois bras d'impédance de condensateur adoptent des condensateurs (8) et des plaques d'impédance (9) d'un même modèle et de mêmes spécifications.

3. Appareil de détection de PD basé sur un boîtier d'interconnexion croisée (1) selon la revendication 1, dans lequel il y a un processeur (11), et les trois modules de détection de signal d'impulsion (10) sont connectés au même processeur (11).

4. Procédé de détection de PD utilisant l'appareil de détection de PD basé sur un boîtier d'interconnexion croisée (1) selon la revendication 1, dans lequel le procédé comprend les étapes suivantes :
installer les câbles (12) dans le boîtier d'interconnexion croisée (1) ; obtenir un signal de tension d'impulsion de chaque bras d'impédance de condensateur en temps réel ; et détecter un signal PD sur la base du signal de tension d'impulsion.
